# EUROPEAN PATENT APPLICATION

(11) **EP 4 633 327 A2**
(43) Date of publication of application: **15.10.2025**
(21) Application number: 25167205.1
(22) Date of filing: 28.03.2025
(51) Int. Cl.: H10D 89/10, H10D 84/01, H10D 84/83

(54) **UNBIASED DEVICES UNDER DRAIN AND SOURCE INTERCONNECT OF CIRCUIT TRANSISTOR**

(30) Priority: 12.04.2024 US 202418634070
(71) Applicant: Analog Devices International Unlimited Company, Co. Limerick (IE)
(72) Inventor: CANTONI, Adalberto, Limerick (IE); MILLER, Rodney, Limerick (IE); CASEY, David, Limerick (IE); DEFIORE, Anthony Scott, Limerick (IE); POWER, Barry Thomas, Limerick (IE)
(74) Representative: Horler, Philip John

(57) **Abstract**

An electronic circuit includes multiple field effect transistors (FETs). The multiple FETs include multiple circuit transistors having drain and source regions connected to circuits, and multiple floating transistors having unconnected and floating drain, source, and gate regions. The multiple circuit transistors are alternatingly arranged with the multiple floating transistors so that a circuit transistor is arranged adjacent to a floating transistor, and at least a portion of electrically conductive interconnect connected to the circuit transistors is arranged over the drain and source regions of the floating transistors.

## Description

This application claims the benefit of priority from US patent application no. 18/634,070 filed 12 April 2024.

### FIELD OF THE DISCLOSURE

This document pertains generally, but not by way of limitation, to integrated circuit dice or chips. Some embodiments relate to improved layout of integrated circuit elements in an integrated circuit chip.

### BACKGROUND

Integrated circuits (ICs) continue to increase in complexity. Integrated circuits include integrated circuit elements (e.g., transistors) and conductive interconnect to connect such elements. More integrated circuit elements are incorporated into IC chips to increase their functionality. Reducing feature size allows more integrated circuit elements to be incorporated into an IC chip. However, as more elements are included in IC chips, it becomes more difficult to interconnect them. As feature sizes of integrated circuit elements decrease, the conductive connect does not always shrink in scale, yet it is desired to keep the size of IC chips small. Thus, there are general needs for devices, systems and methods that address the interconnect challenges for integrated circuits.

### BRIEF DESCRIPTION OF THE DRAWINGS

In the drawings, which are not necessarily drawn to scale, alike numerals may describe similar components in different views, whilst numerals having different letter suffixes may represent different instances of similar components. The drawings illustrate generally, by way of example, but not by way of limitation, various embodiments discussed in the present document.
FIG. 1 illustrates an example of circuit transistors of an integrated circuit (IC) chip.
FIG. 2 illustrates another example of circuit transistors of an IC chip.
FIG. 3 illustrates an example of an array of multiple transistors arranged in rows and columns of transistors.
FIG. 4 illustrates another example of circuit transistors and floating transistors of an IC chip.
FIGS. 5 and 6 illustrate further examples of an array of multiple transistors.
FIG. 7 is a flow diagram of an example of a method of making an IC.

### DETAILED DESCRIPTION

To meet the demand for increased functional complexity in smaller electronic devices, manufacturers increase the density of integrated circuit elements in an integrated circuit (IC) die or chip. To increase the density, manufacturers strive to reduce the feature size of semiconductor devices used on IC chips.

However, scaling transistor features to smaller size creates challenges in the layout of the devices. Three-dimensional electrically conductive interconnect (e.g., metal interconnect) is used to connect the circuit elements. Closer geometries create higher three-dimensional parasitic couplings. Metals with lower resistance values are used for interconnect to reduce parasitic resistances. This type of interconnect does not scale with the reduced pitch or feature size of semiconductor integrated devices like transistors. This makes it challenging to connect the lower level terminals of transistors.

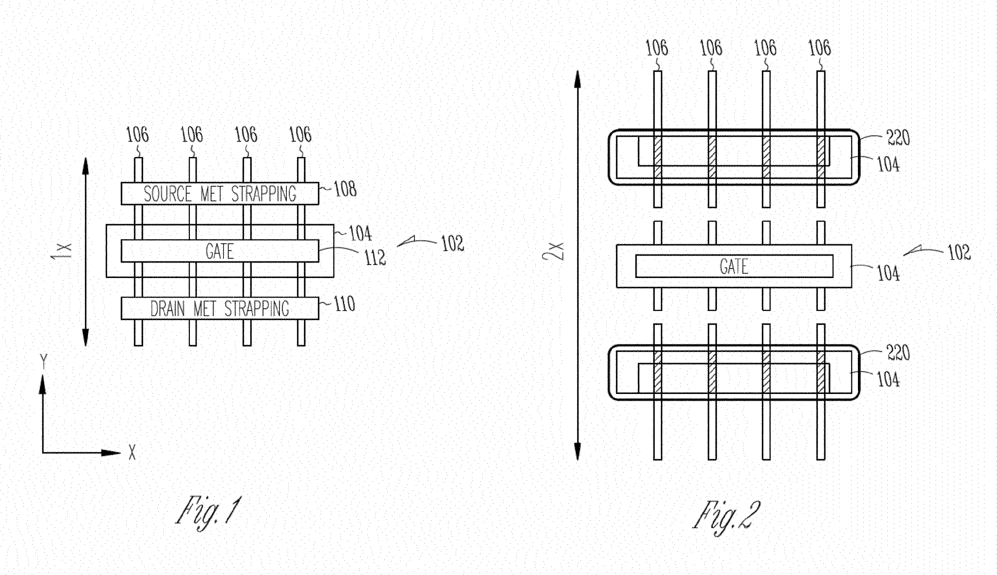

FIG. 1 illustrates an example of circuit transistors 102 of an IC chip. The transistors are field effect transistors (FETs), e.g., metal oxide field effect transistors (MOSFETs). In some examples, the FETs may include FinFETs. The example shows the oxide diffusion (OD) area 104, gate polysilicon 106, source metal strapping 108, drain metal strapping 110, and gate metal 112.

FIG. 2 illustrates another example of circuit transistors 102. The metal interconnect connects the circuit transistors 102 to other circuits of the IC chip. The pitch in the north-south direction (or y-direction) is doubled in FIG. 2 over the pitch in FIG. 1. In addition, floating transistors 220 are added on the north side and the south side of the circuit transistors 102. The floating transistors 220 include the oxide diffusion area 104 and the gate polysilicon 106, but do not include any metal interconnect contacting the drain or source areas of the floating transistors 220. The interconnect for the circuit transistors 102 is routed in the space created by the floating transistors 220. The floating terminals simplify the interconnect to the circuit transistors 102 in the surrounding area. This simplified routing results in better drain to source resistance (Rds) of the circuit transistors. The unbiased devices also reduce overall parasitic source capacitance (Cs) and parasitic drain capacitance (Cd).

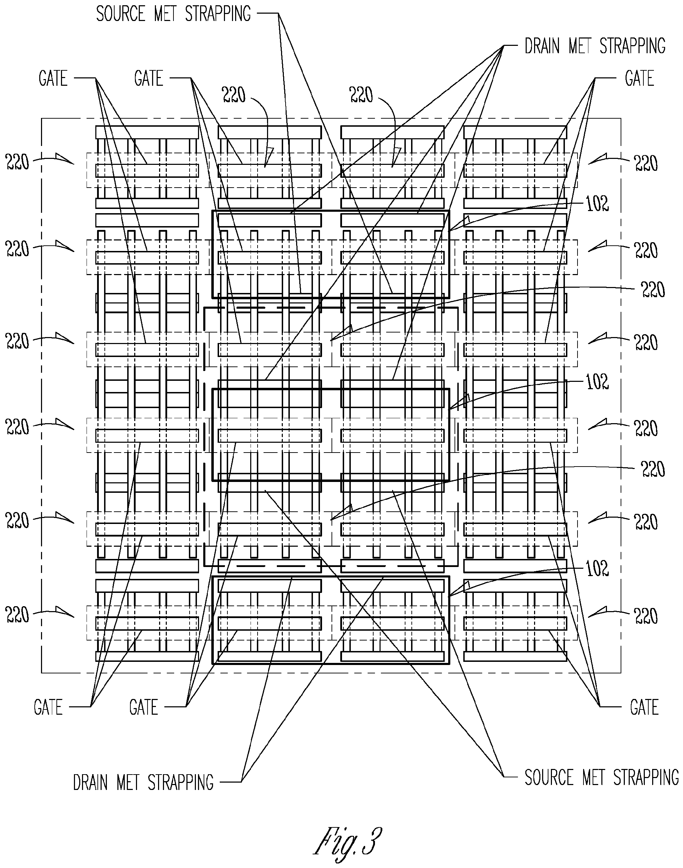

FIG. 3 illustrates an example of an array of multiple FETs arranged in rows and columns. The FETs include circuit transistors 102 and floating transistors 220. The circuit transistors 102 have drain, source, and gate regions connected to other circuits or circuit elements of the IC chip. The floating transistors 220 are unconnected and have floating drain, source, and gate regions. The example includes only two circuit transistors 102 in a row of circuit transistors to simplify the diagram for explanation purposes. An actual implementation may have hundreds of circuit transistors 102 in a row.

The rows of circuit transistors 102 are alternatingly arranged with the floating transistors 220 so that a circuit transistor 102 is adjacent to a floating transistor 220 to the north and south of the circuit transistor 102 as shown in the example of FIG. 2. The pitch in the column direction is greater than the pitch in the row direction as in the example of FIG. 2. At least a portion of the interconnect to the circuit transistors 102 is routed over the floating drain, source, and gate regions of the floating transistors 220. The example in FIG. 3 shows a row of floating transistors 220 alternating with rows of circuit transistors 102. In another example arrangement, columns of floating transistors 220 are alternated with columns of circuit transistors 102.

In the example of FIG. 3, a periphery of floating transistors 220 surrounds the alternating circuit transistors 102 and floating transistors 220. A bottom peripheral row of floating transistors 220 is not shown in FIG. 3 to simplify the diagram. None of the floating transistors 220 in the periphery are connected to a voltage plane or a ground plane.

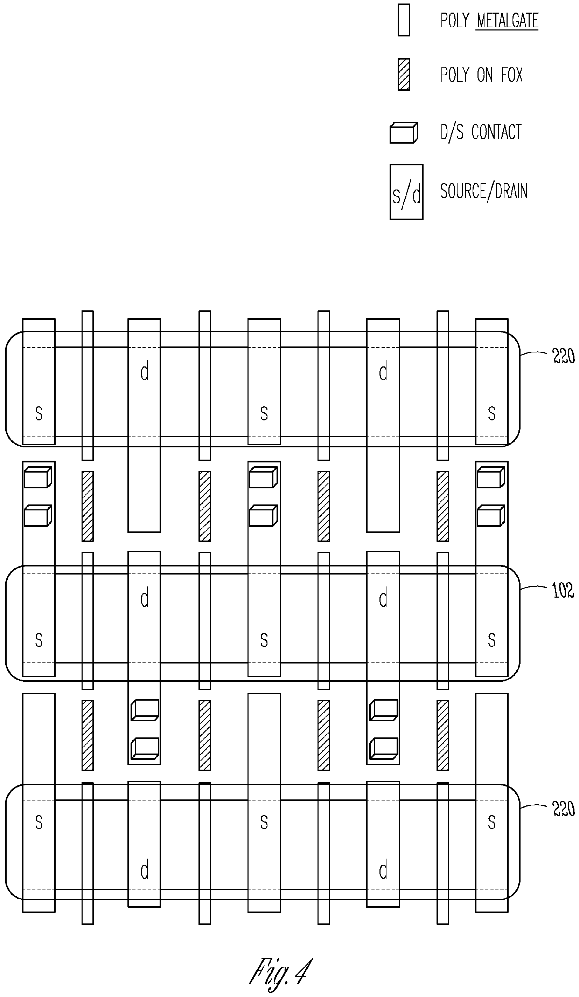

FIG. 4 illustrates another example of circuit transistors 102 and floating transistors 220. The example of FIG. 4 shows the source (s) and drain (d) regions of the circuit transistors 102 and the floating transistors 220. FIG. 4 also shows the polysilicon (poly) and poly on field oxide (poly on Fox) of the gate regions of the circuit transistors 102 and the floating transistors 220. FIG. 4 shows the contacts for the drain and source regions of the circuit transistors 102. The drain, source, and gate regions of the floating transistors 220 are all floating and do not contact the interconnect that is routed to the circuit transistors 102. FIG. 4 shows that the floating transistors 220 may be fully functional transistors if metal interconnect is connected to the drain, source, and gate regions of the floating transistors 220.

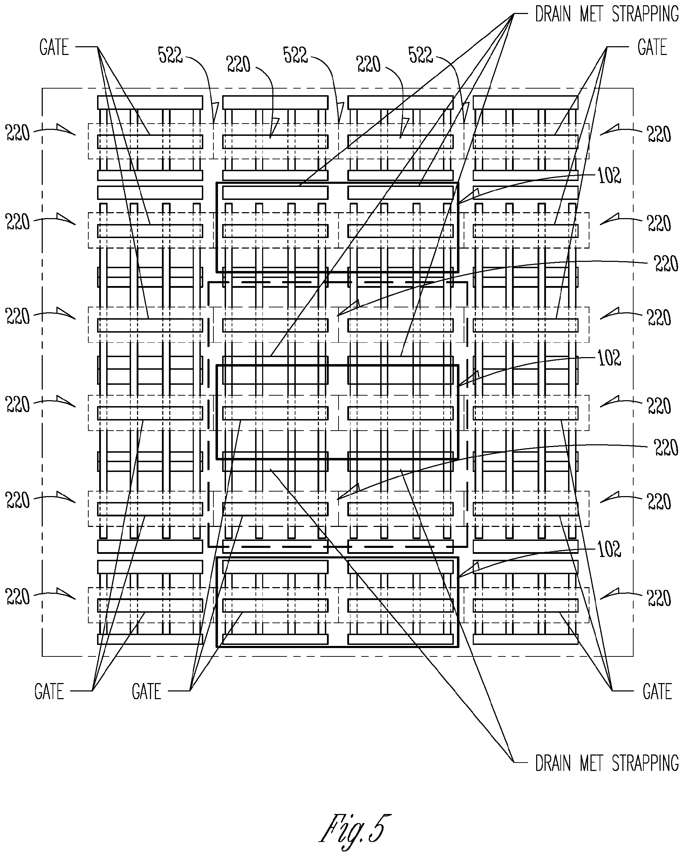

Returning to FIG. 3, the rows of circuit transistors 102 and floating transistors 220 have a continuous oxide diffusion area across the rows of FETs. FIG. 5 illustrates another example of an array of multiple FETs arranged in rows and columns. In the example of FIG. 5, the transistor layout is modular and the rows of circuit transistors 102 and floating transistors 220 have separations 522 in the oxide diffusion areas across the rows of FETs.

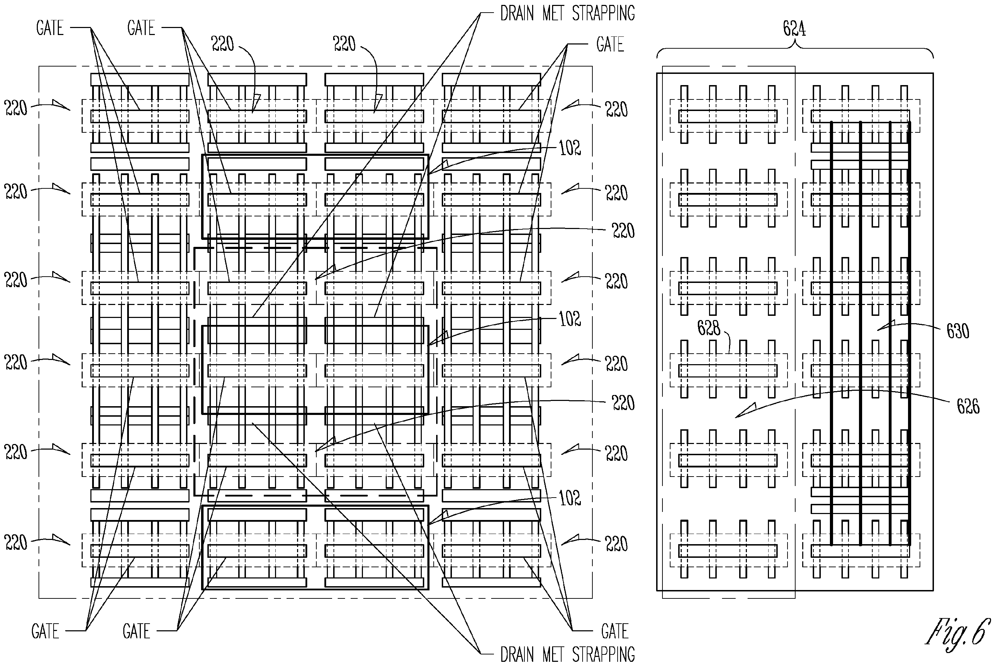

FIG. 6 illustrates another example of an array of circuit transistors 102 and floating transistors 220 arranged in rows and columns. As in the example of FIG. 3, a periphery of floating transistors 220 surrounds the alternating circuit transistors 102 and floating transistors 220. In the example of FIG. 6, a guard ring area 624 surrounds the alternating circuit transistors 102 and floating transistors 220 and the periphery floating transistors 220. The guard ring area 624 is shown only on one side of the array of FETs to simplify the diagram. The guard ring area 624 includes devices that are a different type than the alternating circuit transistors 102 and floating transistors 220. The alternating circuit transistors 102 and floating transistors 220 may be n-type FETs, and the guard ring area 624 includes p-type floating devices. Alternatively, the alternating circuit transistors 102 and floating transistors 220 may be p-type FETs, and the guard ring area 624 includes n-type floating devices.

The guard ring area 624 includes area 626. The devices 628 in area 626 are floating structures. The structures may be transistors except for the lack of metal interconnect contacting the drain, source, and gate regions. However, the devices may not be functioning transistors as they have the same diffusion as the substrate. The area 630 of the guard ring outside area 626 includes devices in which the structure regions (e.g., drain source regions) may serve as substrate ties and may be tied to either circuit ground or a voltage plane, depending on whether the devices are n-type or p-type. The poly regions of the devices in area 630 may be floating.

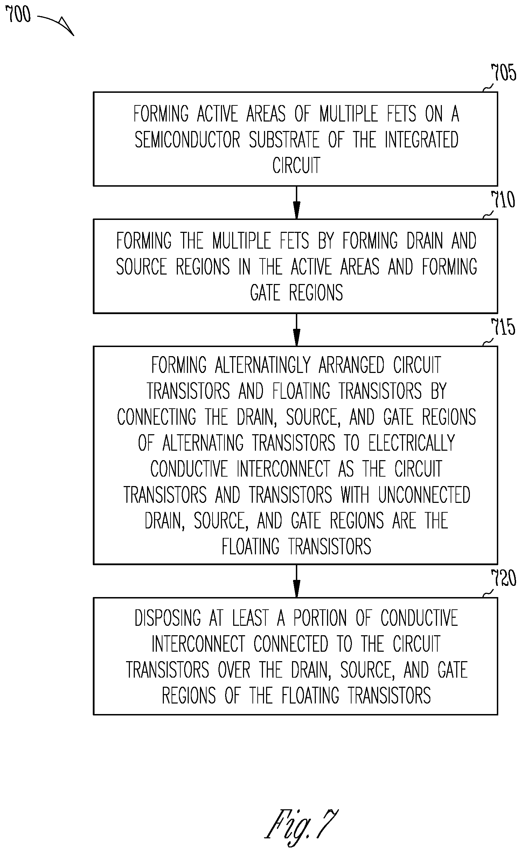

FIG. 7 is a flow diagram of an example of a method 700 of making an IC. At block 705, active areas of multiple FETs are formed on a semiconductor substrate of the IC. The FETs may be FinFETs. Forming the active areas may include forming rows of oxide diffusion for the active areas. In certain examples, the rows are continuous and in certain examples, the rows of oxide diffusion are separated and modularized.

At block 710, the multiple FETs are created by forming drain and source regions in the active areas and forming gate regions for the FETs on the active areas. The FETs may be formed in an array of rows and columns of FETS.

At block 715, alternatingly arranged circuit transistors and floating transistors are created. The circuit transistors are formed by connecting the drain, source, and gate regions to electrically conductive interconnect. The floating transistors are the transistors with unconnected drain, source, and gate regions. In some examples, the circuit transistors are formed by connecting alternating rows of transistors to form rows of circuit transistors, and the drain, source, gate regions of transistors of rows on either side of the circuit transistors are unconnected forming regions of floating transistors.

In some examples, forming the alternatingly arranged circuit transistors and floating transistors includes forming the transistors with greater pitch between rows than the pitch between transistors within a row. The circuit transistors may be formed by connecting alternating columns of transistors to form columns of circuit transistors, and the drain, source, gate regions of transistors of columns on either side of the circuit transistors are unconnected and are floating regions.

At block 720, at least a portion of conductive interconnect connected to the circuit transistors is disposed or routed over the drain, source, and gate regions of the floating transistors. A periphery of floating transistors can be formed around the rows and columns of alternating or interlaced circuit transistors and floating transistors. In some examples, a guard ring is formed around the periphery of floating transistors.

System and methods have been described for interconnecting semiconductor devices such as transistors within integrated circuit chips with dense geometries. The extra area provided by the floating transistors in the vicinity of the circuit transistors allows for routing channels to connect the circuit transistors.

### ADDITIONAL DESCRIPTION AND EXAMPLES

A first Example (Example 1) includes subject matter (such as an electronic device) comprising multiple field effect transistors (FETs). The FETs include multiple circuit transistors having drain and source regions connected to circuits, and multiple floating transistors having unconnected and floating drain, source, and gate regions. The multiple circuit transistors are alternatingly arranged with the multiple floating transistors so that a circuit transistor is arranged adjacent to a floating transistor, and at least a portion of electrically conductive interconnect connected to the circuit transistors is arranged over the drain and source regions of the floating transistors.

In Example 2, the subject matter of Example 1 optionally includes the FETs arranged as an array of transistors with columns and rows of transistors, and rows of circuit transistors alternate with rows of floating transistors in the array of transistors.

In Example 3, the subject matter of Example 2 optionally includes the FETs including oxide diffusion areas, and wherein the array of transistors includes separations in the oxide diffusion areas between transistors.

In Example 4, the subject matter of Example 2 optionally includes the FETs including oxide diffusion areas, and wherein the array of transistors includes separations in the oxide diffusion areas between transistors.

In Example 5, the subject matter of Example 1 optionally includes the FETs arranged as an array of transistors with columns and rows of transistors, and columns of circuit transistors alternate with columns of floating transistors in the array of transistors.

In Example 6, the subject matter of one or any combination of Examples 1-5 optionally includes FETs arranged as an array of transistors with columns and rows of transistors, and peripheral rows and peripheral columns of the transistors include all floating transistors that are not connected to a voltage or ground plane.

In Example 7, the subject matter of one or any combination of Examples 1-6 optionally includes a pitch between FETs in a column direction is greater than a pitch between FETs in a row direction.

In Example 8, the subject matter of one or any combination of Examples 1-7 optionally includes the drain and source regions of the floating transistors are not electrically connected to a voltage plane or a ground plane.

In Example 9, the subject matter of one or any combination of Examples 1-8 optionally includes the multiple FETs including FinFets.

In Example 10, the subject matter of one or any combination of Examples 1-9 optionally includes the electrically conductive interconnect including metal, with no metal contacting the drain, source, or gate regions of the floating transistors.

Example 11 includes subject matter (such as a method of making an integrated circuit) or can optionally by combined with one or nay combination of Examples 1-10 to include such subject matter, comprising forming active areas of multiple field effect transistors (FETs) on a semiconductor substrate of the integrated circuit, forming the multiple FETs by forming drain and source regions in the active areas and forming gate regions, forming alternatingly arranged circuit transistors and floating transistors by connecting the drain, source, and gate regions of alternating transistors to electrically conductive interconnect as the circuit transistors and having unconnected drain, source, and gate regions as the floating transistors, and disposing at least a portion of conductive interconnect connected to the circuit transistors over the drain and source regions of the floating transistors.

In Example 12, the subject matter of Example 11 optionally includes forming an array of columns and rows of the multiple FETs, connecting the drain, source, and gate regions of FETs in a row of FETs to form a row of circuit transistors with a row of floating transistors on either side of the row of circuit transistors, and routing the at least a portion of the electrically conductive interconnect over the floating transistors of the rows of floating transistors.

In Example 13, the subject matter of one or both of Examples 11 and 12 optionally includes forming continuous rows of oxide diffusion for the active areas and forming an array of columns and rows of active areas for the multiple FETs in the rows of oxide diffusion.

In Example 14, the subject matter of one or both of Examples 11 and 12 optionally includes forming rows of separated areas of oxide diffusion for the active areas, and forming an array of columns and rows of active areas for the multiple FETs, wherein the active areas in a row are formed in the separated oxide diffusion areas.

In Example 15, the subject matter of one or any combination of Examples 11-14 optionally includes forming an array of columns and rows of the multiple FETs, connecting the drain, source, and gate regions of FETs in a column of FETs to form a column of circuit transistors with a column of floating transistors on either side of the column of circuit transistors, and routing the at least a portion of the electrically conductive interconnect over the floating transistors of the columns of floating transistors.

In Example 16, the subject matter of one or any combination of Examples 11-15 optionally includes forming an array of columns and rows of the multiple FETs, and not connecting any of the FETs of peripheral columns and rows of FETs to the electrically conductive interconnect so that the peripheral columns and rows include all floating transistors.

In Example 17, the subject matter of one or any combination of Examples 11-16 optionally includes forming the FETs in an array including columns of FETs and rows of FETs such that a pitch of FETs between the rows of FETs is greater than a pitch of FETs between the columns of FETs.

In Example 18, the subject matter of one or any combination of Examples 11-17 optionally includes forming multiple FinFETs included in the FETs.

In Example 19, the subject matter of one or any combination of Examples 11-18 optionally includes forming n-type FETs, forming alternatingly arranged n-type circuit FETs and n-type floating FETs, and forming a guard ring of p-type floating devices around the n-type circuit FETs and n-type floating FETs.

In Example 20, the subject matter of one or any combination of Examples 11-18 optionally includes forming p-type FETs, forming alternatingly arranged p-type circuit FETs and p-type floating FETs, and forming a guard ring of n-type floating devices around the p-type circuit FETs and p-type floating FETs.

These non-limiting examples can be combined in any permutation or combination. The above detailed description includes references to the accompanying drawings, which form a part of the detailed description. The drawings show, by way of illustration, specific embodiments in which the invention can be practiced. These embodiments are also referred to herein as "examples." All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects. Method examples described herein can be machine or computer-implemented at least in part.

## Claims

1. An electronic device comprising:
multiple field effect transistors (FETs);
wherein the multiple FETs include multiple circuit transistors having drain and source regions connected to circuits, and multiple floating transistors having unconnected and floating drain, source, and gate regions;
wherein the multiple circuit transistors are alternatingly arranged with the multiple floating transistors so that a circuit transistor is arranged adjacent to a floating transistor; and
wherein at least a portion of electrically conductive interconnect connected to the circuit transistors is arranged over the drain and source regions of the floating transistors.

2. The electronic device of claim 1,
wherein the multiple FETs are arranged as an array of transistors with columns and rows of transistors; and
wherein rows of circuit transistors alternate with rows of floating transistors in the array of transistors.

3. The electronic device of claim 2,
wherein the multiple FETs include oxide diffusion areas, and wherein the array of transistors includes separations in the oxide diffusion areas between transistors, or
wherein the multiple FETs include oxide diffusion areas, and wherein the oxide diffusion areas are continuous between rows of transistors of the array of transistors.

4. The electronic device of any preceding claim,
wherein the multiple FETs are arranged as an array of transistors with columns and rows of transistors; and
wherein columns of circuit transistors alternate with columns of floating transistors in the array of transistors.

5. The electronic device of any preceding claim,
wherein the multiple FETs are arranged as an array of transistors with columns and rows of transistors; and
wherein peripheral rows and peripheral columns of the transistors include all floating transistors that are not connected to a voltage or ground plane.

6. The electronic device of any preceding claim, wherein a pitch between FETs in a column direction is greater than a pitch between FETs in a row direction.

7. The electronic device of any preceding claim, wherein the drain and source regions of the floating transistors are not electrically connected to a voltage plane or a ground plane.

8. The electronic device of any preceding claim, wherein the FETs include FinFETs.

9. The electronic device of any preceding claim, wherein the electrically conductive interconnect includes metal, and no metal contacts the drain, source, or gate regions of the floating transistors.

10. A method of making an integrated circuit, the method comprising:
forming active areas of multiple field effect transistors (FETs) on a semiconductor substrate of the integrated circuit;
forming the multiple FETs by forming drain and source regions in the active areas and forming gate regions;
forming alternatingly arranged circuit transistors and floating transistors by connecting the drain, source, and gate regions of alternating transistors to electrically conductive interconnect as the circuit transistors and having unconnected drain, source, and gate regions as the floating transistors; and
disposing at least a portion of conductive interconnect connected to the circuit transistors over the drain and source regions of the floating transistors.

11. The method of claim 10,
wherein the forming the multiple FETs includes forming an array of columns and rows of the multiple FETs; and
wherein the forming the alternatingly arranged circuit transistors and floating transistors includes:
connecting the drain, source, and gate regions of FETs in a row of FETs to form a row of circuit transistors with a row of floating transistors on either side of the row of circuit transistors; and
routing the at least a portion of the electrically conductive interconnect over the floating transistors of the rows of floating transistors.

12. The method of claim 10 or claim 11, wherein the forming active areas includes:
forming continuous rows of oxide diffusion for the active areas; and
forming an array of columns and rows of active areas for the multiple FETs in the rows of oxide diffusion.

13. The method of any of claims 10 to 12, wherein the forming active areas includes:
forming rows of separated areas of oxide diffusion for the active areas; and
forming an array of columns and rows of active areas for the multiple FETs, wherein the active areas in a row are formed in the separated oxide diffusion areas.

14. The method of any of claims 10 to 13,
wherein the forming the multiple FETs includes forming an array of columns and rows of the multiple FETs; and
wherein the forming the alternatingly arranged circuit transistors and floating transistors includes:
connecting the drain, source, and gate regions of FETs in a column of FETs to form a column of circuit transistors with a column of floating transistors on either side of the column of circuit transistors; and
routing the at least a portion of the electrically conductive interconnect over the floating transistors of the columns of floating transistors.

15. The method of any of claims 10 to 14, wherein at least one of the following applies:
(a) the forming the multiple FETs includes forming an array of columns and rows of the multiple FETs; and not connecting any of the FETs of peripheral columns and rows of FETs to the electrically conductive interconnect so that the peripheral columns and rows include all floating transistors;
(b) the forming the multiple FETs includes forming the FETs in an array including columns of FETs and rows of FETs such that a pitch of FETs between the rows of FETs is greater than a pitch of FETs between the columns of FETs;
(c) wherein the forming the multiple FETs includes forming multiple FinFETs;
(d) the forming the multiple FETs includes:
forming n-type FETs;
forming alternatingly arranged n-type circuit FETs and n-type floating FETs; and
forming a guard ring of p-type floating devices around the n-type circuit FETs and n-type floating FETs;
(e) the forming the multiple FETs includes:
forming p-type FETs;
forming alternatingly arranged p-type circuit FETs and p-type floating FETs; and
forming a guard ring of n-type floating devices around the p-type circuit FETs and p-type floating FETs.
